# EUROPÄISCHE PATENTSCHRIFT

(11) **EP 2 399 439 B1**
(45) Veröffentlichungstag und Bekanntmachung des Hinweises auf die Patenterteilung: **05.08.2015**
(21) Anmeldenummer: 10705296.1
(22) Anmeldetag: 17.02.2010
(51) Int. Cl.: H05K 7/14

(54) **SCHALTSCHRANK ODER RACK**
SWITCHGEAR CABINET OR RACK
ARMOIRE DE COMMANDE OU BAIE

(30) Priorität: 19.02.2009 DE 102009009639
(43) Veröffentlichungstag der Anmeldung: 28.12.2011
(73) Patentinhaber: Rittal GmbH & Co. KG, 35745 Herborn (DE)
(72) Erfinder: THIELMANN, Bodo, 35768 Siegbach (DE); HAIN, Markus, 35684 Dillenburg (DE); SCHMIDT, Volker, 57076 Siegen (DE)
(74) Vertreter: Angerhausen, Christoph
(86) Internationale Anmeldenummer: PCT/EP2010/000982
(87) Internationale Veröffentlichungsnummer: WO 2010/094460

(56) Entgegenhaltungen:
- WO-A1-2005/083856
- WO-A2-2006/047122
- DE-A1-102007 034 437
- US-A1- 2008 265 722
- US-A1- 2009 108 995

## Beschreibung

Die Erfindung bezieht sich auf einen Schaltschrank oder ein Rack mit einer Montageeinrichtung, die einen Einbauraum für anwenderseitige Einbaueinheiten frontseitig seitlich begrenzende vertikale Montageprofile mit frontseitigen flachen Befestigungsabschnitten zum Anbringen von seitlich abstehenden Montageabschnitten der Einbaueinheiten aufweist, und mit Komponenten einer Erfassungseinrichtung zum Feststellen, ob an einer Einbauposition des Einbauraums eine Einbaueinheit vorhanden ist oder nicht, wobei die Komponenten der Erfassungseinrichtung eine an einem Montageprofil angebrachte vertikal verlaufende Antennenleiste mit darin angeordneten Antennenelementen und an den Einbaueinheiten angeordneten Transponderelementen aufweisen, wobei das Montageprofil eine an den Querschnitt der Antennenleiste zumindest teilweise angepasste, nach vorne zur Frontseite offene, seitlich außerhalb des benachbarten Befestigungsabschnittes angeordnete Aufnahme mit einem gegenüber der frontseitigen Ebene des Befestigungsabschnitts zumindest um die Querschnittstiefe der Antennenleiste zurückversetzten Anlageabschnitt und mit einer die Aufnahme auf deren dem Einbauraum zugekehrter Seite begrenzenden innenseitigen Begrenzungswand aufweist, die sich zur Außenseite an den Befestigungsabschnitt anschließt.

Ein derartiger Schaltschrank bzw. derartiges Rack ist in der DE 10 2007 034 437 A1 angegeben. Bei diesem bekannten Schaltschrank ist eine Vorrichtung zum Erkennen von darin aufgenommenen Einbaueinheiten mit einer Erfassungseinheit ausgerüstet, die an eine Auswerte-oder Registriereinrichtung angeschlossen oder anschließbar ist. Die Erfassungseinheit weist dabei in einer Ausgestaltung eine in der Montageebene der Einbaueinheiten angeordnete, an einem Rahmenschenkel oder Montageteil angeschraubte oder aufgeklebte Antennenleiste mit im Raster von einer oder mehreren Höheneinheiten positionierten, berührungslos ansprechenden Antennenelementen und an den Einbaueinheiten angeordnete Transponder, insbesondere RFIDTags auf. Die leistenformige Antennenanordnung kann sich dabei aus mehreren mit Stecker-/Kupplungseinheiten zusammengesteckten Antennenmodulen zusammensetzen, die jeweils ein schmales, sich längs erstreckendes, leistenartiges Kunststoffgehäuse zur Abdeckung mehrerer Höheneinheiten aufweisen. Das Gehäuse, das sich auch über die gesamte Höhe des Aufnahmebereichs für die Einbaueinheiten erstrecken kann, besitzt Befestigungsmöglichkeiten zum Anbringen z. B. an einer vertikalen Montageschiene, an der auch die Einbaueinheiten festgelegt sind. Die Transponder bzw. RFID-Tags sind im vorderen Bereich der Einbaueinheiten, insbesondere Servereinheiten, an deren Gehäuse nahe der Antennenleiste positioniert, so dass die Antennenelemente im Nahfeld der jeweils zugeordneten Transponder deren Information auslesen, die über eine Datenleitung oder alternativ drahtlos zu der Auswerte- und Registriereinrichtung übertragen wird. Das jeweilige RFID-Tag besitzt eine eindeutige Identifikation und kennzeichnet die zu erfassende Einbaueinheit, die über die betreffenden Antennenelemente unter Steuerung durch eine Steuereinheit ausgelesen und mit der zugehörigen Höhenposition an die Auswerteeinheit übermittelt wird. Die Befestigung der RFID-Tags an der Einbaueinheit erfolgt durch Kleben oder Schrauben. Die eindeutige Identifikation des so aufgebauten passiven Transponders bzw. RFID-Tags erfolgt bereits im Herstellungswerk.

In der WO 2006/047122 A2 ist ein Schaltschrank bzw. Reck mit von der Frontseite her eingebauten Einbaueinheiten gezeigt, wobei im seitlichen Bereich eine Erfassungseinrichtung zum Bereitstellen von Information über die Einbaueinheiten, angeordnet ist.

Auch in der US 2008/265722 A1 ist ein Schaltschrank oder Rack mit Einbaueinheiten und zugeordneter Erfassungseinrichtung gezeigt.

Zwar ergibt die Anordnung der Antennenleiste im Bereich der Einbauebene des Schaltschranks oder Racks vorteilhafte Montagemöglichkeiten und eine günstige Signalerfassung in Verbindung mit den Transpondern. Jedoch kann es durch ungenaue Montage zu Störungen in der Signalerfassung und Signalübertragung und damit unzuverlässiger Positionserfassung oder Zuordnung von Identifikationen kommen.

Der Erfindung liegt die Aufgabe zugrunde, einen Schaltschrank oder Rack der eingangs genannten Art bereitzustellen, bei dem eine ungenaue oder fehlerhafte Montage der Erfassungseinrichtung möglichst ausgeschlossen wird.

Diese Aufgabe wird mit den Merkmalen des Anspruches 1 gelöst. Hierbei ist vorgesehen, dass sich an den Befestigungsabschnitt zur Außenseite eine innenseitige Begrenzungswand der Aufnahme für die Antennenleiste anschließt, wobei die innenseitige Begrenzungswand an ihrem von der Frontseite abliegenden rückseitigen Ende rechtwinklig in den nach außen zeigenden Anlageabschnitt übergeht, der parallel zu der Montageebene ausgerichtet ist, wobei eine Rückseite der Antennenleiste beim Einsetzen an den Anlageabschnitt in Anlage gebracht ist, wobei die Vorderseite des Anlageabschnitts in einem solchen Abstand von der frontseitigen Montageebene zurückversetzt ist, dass die Vorderseite der Antennenleiste nicht über die Frontebene der Befestigungsabschnitte übersteht, und wobei die Antennenleiste mit ihrer Frontseite in der Montageebene liegt oder gegenüber dieser im höchstens 10 mm zurückversetzt ist, wobei das jeweilige Transponderelement vor der Frontseite der Antennenleiste angeordnet und auf einem die Antennenleiste überlappenden Tragabschnitt eines Halteelementes befestigt ist, wobei die Transponderelemente und Antennenelemente Transponder- und Antennenelemente sind.

Mit diesen Maßnahmen wird eine eindeutige, genaue Montage der Antennenleiste erreicht und eine exakte Zuordnung der Transponderelemente zu der Antennenleiste ermöglicht.

Eine lagegenaue Anordnung der Antennenleiste wird dadurch begünstigt, dass der Anlageabschnitt und die innenseitige Begrenzungswand im Querschnitt der Aufnahme rechtwinklig zueinander angeordnet sind, wobei der Anlageabschnitt parallel zur Montageebene ausgerichtet ist.

Für die Montage und den Aufbau ist vorteilhaft vorgesehen, dass die Begrenzungswand rechtwinklig in den Befestigungsabschnitt übergeht.

Ein stabiler Aufbau und zusätzliche Montagemöglichkeiten werden dadurch erreicht, dass der Anlageabschnitt über einen Zwischenabschnitt oder unmittelbar schräg oder rechtwinklig in einen von der Frontseite weg nach hinten gerichteten Seitenwandabschnitt übergeht oder rechtwinklig in eine nach vorn zur Frontseite hin gerichteten und höchstens bis in diese vorstehende außenseitige Begrenzungswand der Aufnahme übergeht.

Eine weitere vorteilhafte Ausgestaltung besteht darin, dass die außenseitige Begrenzungswand über einen Zwischenabschnitt oder unmittelbar in den rechtwinklig oder schräg zur vorderen Schaltschrank- oder Rackebene gerichteten Seitenwandabschnitt übergeht.

Eine vorteilhafte Montage ergibt sich ferner dadurch, dass die Befestigungsabschnitte in einer gemeinsamen Montageebene liegen und zum Anschlagen der Montageabschnitte ausgebildet sind und vertikale Lochreihen mit einem oder mehreren in einem regelmäßigen Rasterabstand angeordneten Befestigungslöchern aufweisen.

Zu einer genauen Zuordnung von Code-Trägern und Detektorelementen, beispielsweise Transponderelementen und Antennenelementen, wird dadurch erreicht, dass die Detektorleiste mit ihrer Frontseite in der Montageebene liegt oder gegenüber dieser um höchstens 10 mm zurückversetzt ist und dass der jeweilige Code-Träger vor der Frontseite der Detektorleiste angeordnet und auf einem die Detektorleiste überlappenden Tragabschnitt eines Halteelementes befestigt ist, das mit einem Verbindungsabschnitt an dem benachbarten Montageabschnitt der zugeordneten Einbaueinheit angebracht ist.

Die Montage und eine lagegenaue Anordnung der Detektorleiste werden ferner dadurch begünstigt, dass in dem Anlageabschnitt eine Haltelochreihe mit in regelmäßigem Rasterabstand angeordneten Haltelöchern angeordnet ist.

Ein für die Montage vorteilhafter Aufbau besteht darin, dass die Haltelöcher quadratisch oder rechteckförmig mit in Längsrichtung des Montageprofils verlaufenden Längsseiten ausgebildet sind und dass die Detektorleiste auf ihrer dem Anlageabschnitt zugekehrten Rückseite mit Haltehaken versehen ist, die auf den Abstand der Haltelöcher oder ein Vielfaches davon abgestimmt sind und vertikale Hakenabschnitte aufweisen, die eine geringere Länge besitzen als die lichte Öffnungsweite der Haltelöcher in vertikaler Richtung und die soweit von der rückseitigen Außenfläche der Detektorleiste beabstandet sind, dass sie einen die Haltelöcher umgebenden Wandbereich des Anlageabschnitts mit einer Klemmkraft hintergreifen.

Ein vorteilhafter Aufbau für eine genaue Montage und Zuordnung der Komponenten der Erfassungseinrichtung besteht ferner darin, dass die Detektorleiste quadratischen oder rechteckförmigen Querschnitt besitzt und bezüglich der eingebauten Lage auf ihrer Frontseite mit einem daran fest oder abnehmbar fixierten Abdeckteil versehen ist.

Eine für den Aufbau und die Funktion vorteilhafte Ausbildung besteht darin, dass das Abdeckteil zumindest abschnittsweise transparent ausgebildet ist und dass auf der oder im Inneren der Detektorleiste Leuchtelemente angeordnet sind, die in Längsrichtung der Detektorleiste in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch das transparente Abdeckteil positionsgenau sichtbar sind.

Für die Funktion und den Aufbau vorteilhafte Ausgestaltung besteht darin, dass im Inneren der Detektorleiste im Raster einer Höheneinheit HE oder einem ganzzahligen Vielfachen oder gleichmäßigen Teilabstand davon in Längsrichtung der Detektorleiste voneinander beabstandete Detektorelemente angeordnet sind.

Zu einer genauen Zuordnung zwischen den Code-Trägern und den Detektorelementen tragen ferner die Maßnahmen bei, dass in den Montageabschnitten der Einbaueinheiten auf den Abstand der Befestigungslöcher oder ein ganzzahliges Vielfaches davon abgestimmte Montagelöcher angeordnet sind und dass in den Befestigungsabschnitten der Halteelemente auf die Montagelöcher abgestimmte Öffnungen ange-ordnet sind, wobei der Abstand von der Mitte der Befestigungslöcher bis zum außenseitigen Rand der Anfennenleiste so groß ist wie die Ausdehnung der Halteelemente von der Mitte der Öffnungen zum äußeren Rand des Trageabschnitts.

Die Montage der Erfassungseinrichtung wird ferner dadurch begünstigt, dass die vertikalen Montageprofile sich zwischen einem oberen und unteren horizontalen Montageschenkel oder Rahmenschenkel des Schaltschranks öder Racks erstrecken und dass in Verlängerung der Detektorleiste in ihrer Einbaulage in dem oberen und/oder unteren horizontalen Montageschenkel oder Rahmenschenkel eine Ausdehnung eingebracht ist, die größer ist als der Querschnitt der Detektorleiste.

Eine für die Funktion und den Betrieb vorteilhafte Ausgestaltung besteht darin, dass die Detektorleiste als Antennenleiste ausgebildet ist, die Detektorelemente als Antennenelemente ausgebildet sind und die Code-Träger als Transponderelemente, insbesondere RFID-Tags ausgebildet sind.

Die Erfindung wird nachfolgend anhand von Ausführungsbeispielen unter Bezugnahme auf die Zeichnungen näher erläutert. Es zeigen:
- Fig. 1: eine frontseitige Montageebene eines Schaltschranks oder Racks,
- Fig. 2: einen Ausschnitt eines Einbauraums eines Schaltschranks oder Racks mit vorderer Montageebene und vertikalen Montageprofilen in perspektivischer Ansicht,
- Fig. 3: einen Ausschnitt der Montageebene im Bereich eines Montageabschnittes,
- Fig. 4: eine Detailansicht des Schaltschranks oder Racks in einem oberen vorderen Eckbereich des Einbauraums und der Montageebene mit mehreren eingesetzten Einbaueinheiten,
- Fig. 5: einen Ausschnitt des Schaltschranks oder Racks in einem oberen vorderen Eckbereich mit einer eingesetzten Antennenleiste und einem Halteelement mit Transponder in perspektivischer Ansicht,
- Fig. 6: einen Ausschnitt der Befestigungsebene im Bereich eines Montageabschnittes mit vertikalem Montageprofil, eingesetzter Antennenleiste und angebrachtem Halteelement mit Transponder,
- Fig. 7A bis 7C: eine perspektivische Ansicht, eine Vorderansicht und eine Ansicht auf die rückseitige Stirnseite eines Halteelementes mit Transponderelement,
- Fig. 8: eine perspektivische Ausschnittdarstellung des vorderen oberen Eckbereichs des Schaltschranks oder Racks mit einer Antennenleiste vor deren Einbau,
- Fig. 9A bis 9D: in Fig. 9A eine perspektivische Ansicht eines Abschnitts der Antennenleiste schräg auf die Rückseite; in den Teilbildern a), b) und c) der Fig. 9B die Antennenteiste von der Vorderseite, in einer seitlichen Ansicht und von der Rückseite; in Fig. 9C einen Längsschnitt der Antennenleiste sowie in Fig. 9D einen Querschnitt der Antennenleiste,
- Fig. 10: verschiedene Ansichten des vorderen Montagerahmens des Schaltschranks oder Racks mit seitlichen vertikalen Montageproflen und einem unteren und oberen Rahmenschenkel sowie vergrößerten Ausschnittdarstellungen,
- Fig. 11: den vorderen Montagerahmen des Schaltschranks oder Racks in perspektivischer Ansicht,
- Fig. 12: einen Ausschnitt des Möntagerahmens nach Fig. 11 im Verbindungsbereich zweier auseinander geschobener Leistenmodule und
- Fig. 13: ein Beispiel für eine Bildschirmdarstellung einer Einbauebene eines Schaltschranks oder Racks mit eingesetzten Einbaueinheiten in Form von Servereinheiten.

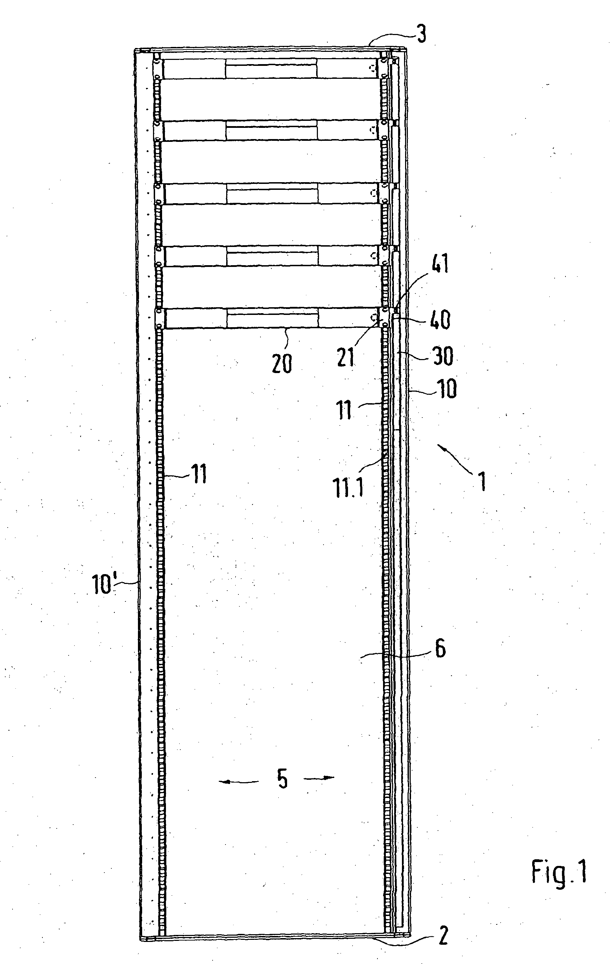

Fig. 1 zeigt eine vorderseitige Ansicht einer Montageebene 5 eines Rahmengestells 1 eines Schaltschranks oder Racks mit mehreren eingebauten Einbaueinheiten 20, wie z. B. Servereinheiten, deren Höhe beispielsweise eine HE beträgt. Die Montageebene 5 ist seitlich durch frontseitige Montageflächen zweier vertikaler Montageprofile 10, 10' und unten von einem unteren Rahmenschenkel 2 sowie oben von einem oberen Rahmenschenkel 3 begrenzt. An den die lichte Einbauöffnung begrenzenden Rändern der Montageprofile 10, 10' schließen sich beidseitig Befestigungsabschnitte 11 der Montageprofile mit Lochreihen 11.1 an, die einen engen Lochrasterabstand von vorliegend drei Befestigungslöchern pro Höheneinheit HE besitzen. Die Montageprofile 10, 10' können durch seitliche Rahmenpiofile des Rahmengestells und/oder durch separate Montageprofile gebildet sein.

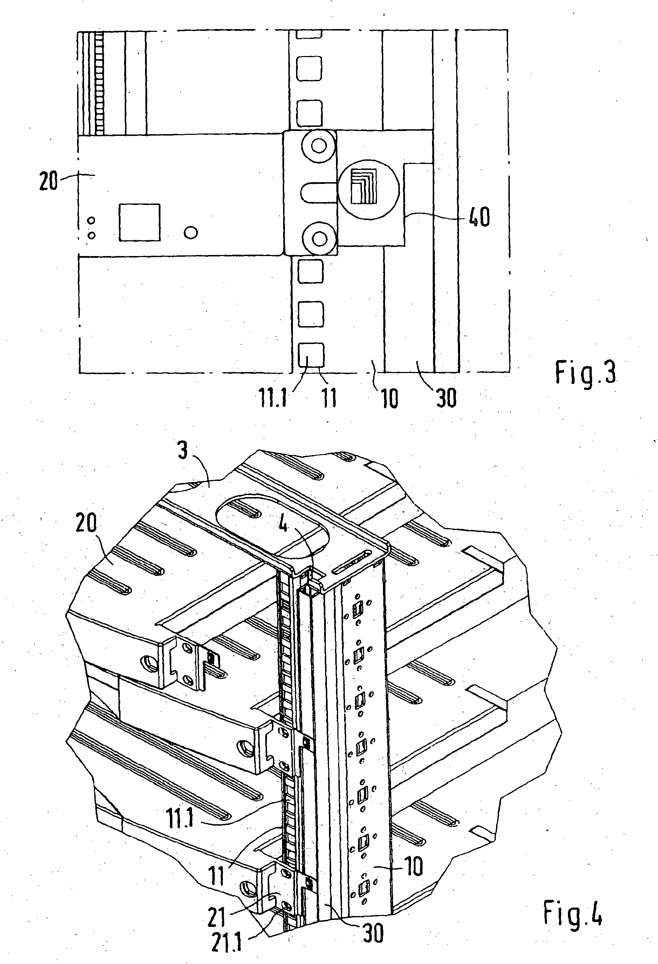

Die Einbaueinheiten 20 weisen seitlich abstehende flasche Montageabschnitte 21 auf, die sich über die Gehäusehöhe der Einbaueinheiten 20, beispielsweise eine oder mehrere Höheneinheiten HE, erstrecken und über die beiderseitigen Befestigungsabschnitte 11 vorstehen. In den Montageabschnitten 21 sind z. B. jeweils zwei Montagelöcher 21.1 (vgl. z. B. auch Fig. 4) vorliegend im doppelten Abstand der Befestigungslöcher 11.2 der Lochreihe 11.1 eingebracht, so dass die Montagelöcher 21.1 jeweils ein Befestigungsloch 11.2 überspringen.

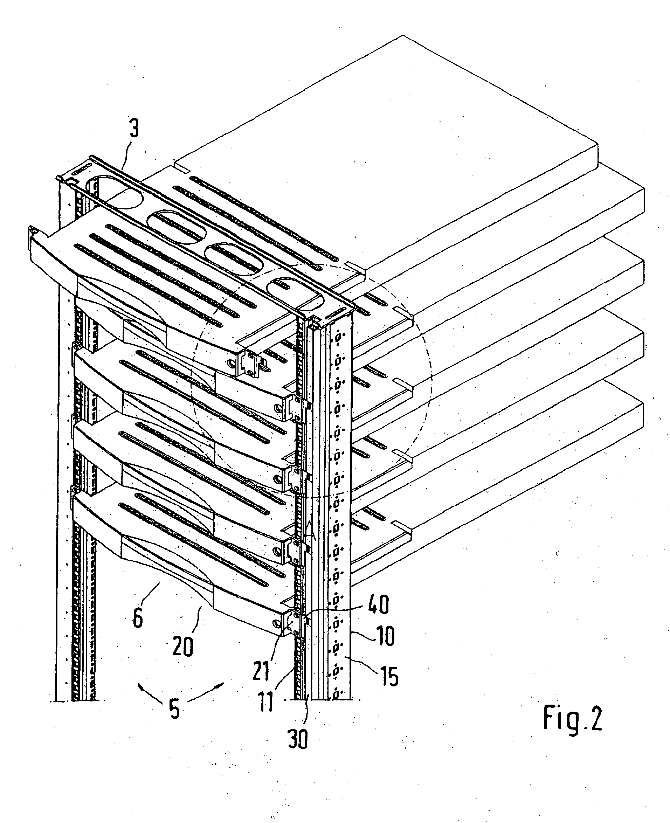

Im Bereich eines seitlichen Montageabschnittes, vorliegend des in Vorderansicht rechten Montageabschnittes 21, sind jeweils Halteelemente 40 angeordnet, beispielsweise an dem Montageabschnitt 21 festgeklebt oder zumindest zwischen diesem und dem Befestigungsabschnitt 11 eingeklemmt, wobei ein zungenartiger Tragabschnitt 41 mit einem darauf angebrachten Code-Träger, beispielsweise Transponderelement 44, seitlich absteht und eine in dem Montageprofil 10 eingesetzte Detektorleiste, beispielsweise Antennenleiste 30, frontseitig überlappt, wie der Ausschnittsdarstellung nach Fig. 2 und den weiteren Darstellungen nach den Fig. 3, 4 und 5 deutlicher zu entnehmen ist.

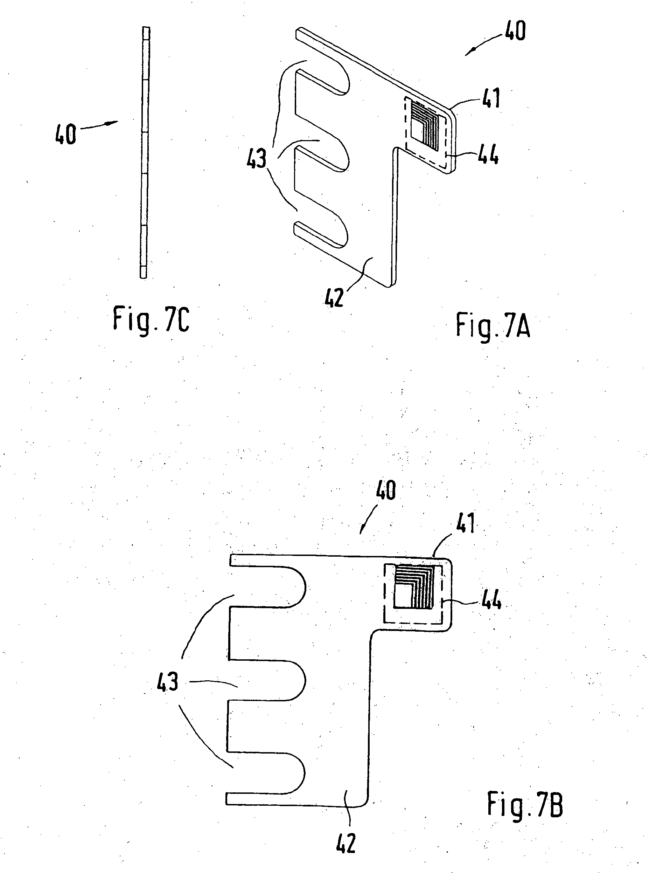

In den Fig. 7A, 7B, 7C ist das Halteelement 40 einzeln in verschiedenen Ansichten wiedergegeben. Die Halteelemente 40 sind aus flachem, plattenförmigem Material geringer Stärke von z. B. höchstens etwa 1 mm beispielsweise aus Metall oder Kunststoff hergestellt, vorzugsweise durch Stanzen oder Schneiden oder aber durch Formen. Das Halteelement 40 weist einen Verbindungsabschnitt 42 mit darin eingebrachten Öffnungen 43 auf, die zu dem von dem Tragabschnitt 41 abgelegenen Rand hin offen sind und eine portalförmige Kontur besitzen. Die im montierten Zustand vertikale Höhenausdehnung entspricht vorzugsweise der Höhe des Montageabschnitts 21, der in der Regel der Gehäusehöhe einer Einbaueinheit, also z. B. einer oder mehreren Höheneinheiten HE entspricht, während die seitliche Breitenäusdehnung des Verbindungsabschnitts 42 in etwa der Breite des Montageabschnittes 21 entspricht, so dass im Montagezustand der außenseitige Rand des Verbindungsabschnitts 42 mit dem außenseitigen Rand des Montageabschnitts 21 in etwa bündig ist und auch der obere und untere Rand des Verbindungsabschnitts 42 und des Montageabschnittes 21 in etwa bündig sind, Der sich nur über einen Bruchteil, z. B. ½, 1/3, % der Höhe des Verbindungsabschnitts 42 erstreckende Tragabschnitt 41, dessen oberer Rand beispielsweise in Verlängerung des oberen Randes des Verbindungsabschnittes verläuft, ist vorzugsweise lichtundurchlässig ausgebildet und trägt das darauf z. B. durch Kleben befestigte Transponderelement 44, insbesondere ausgebildet als RFID-Tag.

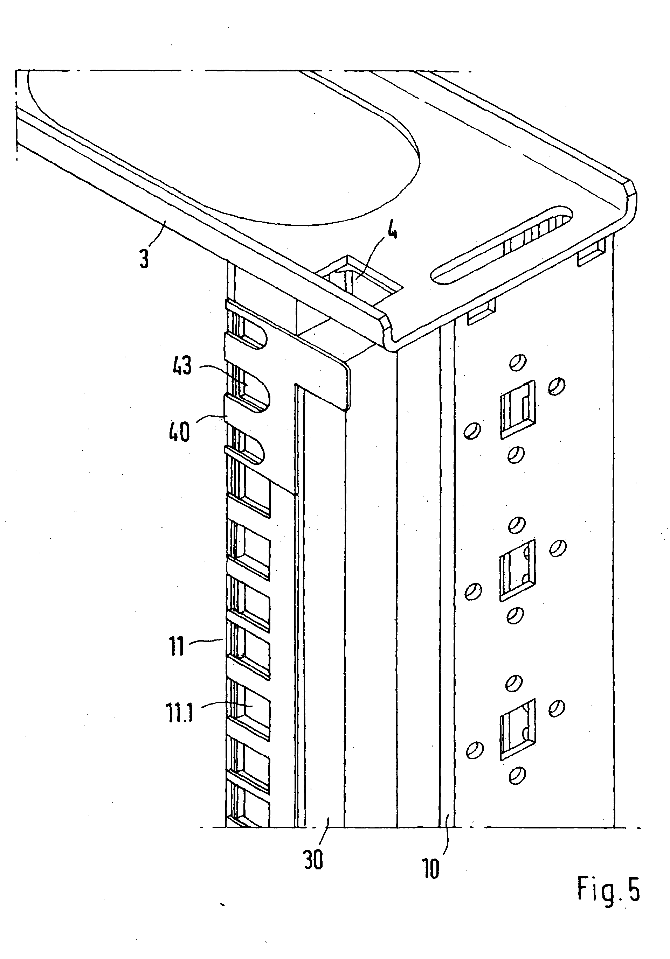

Wie Fig. 2 in perspektivischer Darstellung zeigt, sind die Halteelemente 40, die aus flachem blättchenförmigem Material beispielsweise aus Metall oder Kunststoff hergestellt sind, mit dem Verbindungsabschnitt 42 zwischen der flachen Rückseite des betreffenden Montageabschnittes 21 und der flachen Vorderseite des Befestigungsabschnittes 11 festgespannt, wobei sie zuvor vorteilhaft an dem jeweiligen Montageabschnitt 21 fixiert wurden, beispielsweise mittels einer auf ihnen angebrachten Klebeschicht, die im nicht angebrachten Zustand von einer ablösbaren Schutzfolie abgedeckt ist. In dem Verbindungsabschnitt 42 sind auf die Montagelöcher 21.1 in Lage und Größe abgestimmte Öffnungen 43 eingebracht, so dass die in den Einbauraum 6 eingesetzten und mit ihren Montageabschnitten 21 an den Befestigungsabschnitten 11 anliegenden Einbaueinheiten 20 mittels Schrauben oder ähnlichen Befestigungselementen ungehindert an den Befestigungsabschnitten 11 befestigt werden können, wie Fig. 3 zeigt. Wie ferner aus Fig. 5 ersichtlich, sind dabei auch die Öffnungen 43 der Verbindungsabschnitte 42 mit den betreffenden Befestigungslöchern 11.2 der Lochreihen 11.1 in Deckung gebracht.

Wie die Fig. 2 und insbesondere die vergrößerte Ausschnittsdarstellung nach Fig. 4 sowie auch die Fig. 5, 6 und 8 weiter zeigten, ist zumindest das in Draufsicht rechte Montageprofil, dem die Antennenleiste 30 zugeordnet ist, zur Außenseite an den betreffenden Befestigungsabschnitt 11 anschließend mit einer innenseitigen Begrenzungswand 13 einer Aufnahme 14 für die Antennenleiste 30 versehen. Die innenseitige Begrenzungswand 13 geht an ihrem von der Frontseite abliegenden rückseitigen Ende rechtwinklig in einen nach außen zeigenden Anlageabschnitt 12 in der Tiefe der Aufnahme 14 über, an die die Antennenleiste 30 beim Einsetzen in Anlage gebracht wird. Dabei ist die Vorderseite des Anlageabschnittes 12 von der frontseitigen Montageebene bzw. der Ebene des Befestigungsabschnittes 11 in einem solchen Abstand zurück versetzt, dass die Antennenleiste 30 mit ihrer Vorderseite nicht über die Frontebene des Befestigungsabschnittes 11 übersteht und vorzugsweise mit dieser bündig ist oder nur wenig, z. B. nicht mehr als 10 mm zurückversetzt ist. Besonders bei bündiger Anordnung der Vorderseite der Antennenleiste 30 in der vorderen Montageebene ist der Tragabschnitt 41, auf dessen Rückseite ein insbesondere als RFID-Tag ausgebildetes Transponderelement 44 angebracht, beispielsweise aufgeklebt ist und der die Frontseite der Antennenleiste 30 überlappt, in möglichst geringem Abstand zur Detektorleiste, insbesondere Antennenleiste 30, und darin enthaltenen Detektorelementen, insbesondere Antennenelementen, angeordnet, so dass sich eine geringe Übertragungsdistanz für die drahtlose Informationsübertragung zwischen Code-Träger bzw. Transponderelement 44 und dem betreffenden Detektorelement bzw. Antennenelement ergibt.

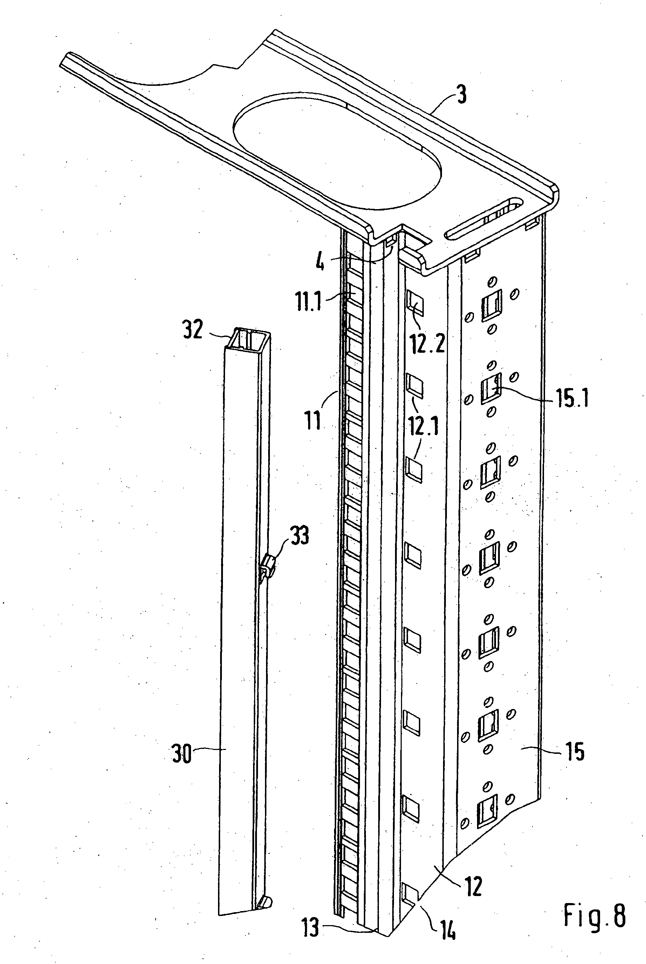

Wie aus Fig. 8 weiter ersichtlich, ist in dem Anlageabschnitt 12 eine Haltelochreihe 12.1 mit mindestens zwei Haltelöchern 12.2 eingebracht, die einen gleichmäßigen Lochrasterabstand in vertikaler Richtung aufweisen, beispielsweise im Abstand einer oder mehrerer Höheneinheiten. Die Haltelöcher 12.2 sind rechteckförmig oder quadratisch geformt und mit ihren Lochbegrehzungsseiten horizontal bzw. vertikal bezüglich der Längsrichtung des Montageprofils 10 bzw. 10' ausgerichtet. Die Antennenleiste 30 ist auf ihrer Rückseite mit Hakenelementen 33 versehen, die beispielsweise durch teilweises Ausstanzen und Ausbiegen aus deren Rückwand hergestellt sind, wobei nach unten gerichtete Hakennasen gebildet sind, die von der Rückwandebene der Antennenleiste 30 um etwas weniger als die Stärke der Wandung des Anlageabschnittes 12 um die Haltelöcher 12.2 beabstandet sind, wobei der nach unten gerichtete Abschnitt an seinem unteren Endabschnitt nach außen von der Rückwandebene der Antennenleiste 30 weggebogen ist, so dass sich ein einfaches Einhängen ergibt. Der nach unten gerichtete Hakenabschnitt ist dabei kürzer als die vertikale Öffnungsweite der Haltelöcher 12.2. Über die Länge der Antennenleiste 30 sind mehrere derartige Hakenelemente angeordnet, die auf den Lochrasterabstand der Haltelöcher 12.2 oder ein Mehrfaches davon abgestimmt sind. Außerdem ist die Breite der Haken auf die Breite der Haltelöcher 12.2 derart abgestimmt, dass sie mit möglichst geringem seitlichem Spiel in die Haltelöcher 12.2 passen. Mit diesen Maßnahmen kann die Antennenleiste 30 einfach und lagegenau in die Aufnahme 14 eingesetzt und mit ihrer Rückseite in Anlage an die Vorderseite des Anlageabschnittes 12 gebracht und anschließend durch Verschieben nach unten fixiert werden, wobei die Haltehaken 33 eine leichte Klemmwirkung ergeben.

Wie Fig. 8 weiter zeigt, ist in dem oberen horizontalen Rahmenschenkel 3, der auch ein Montageschenkel sein kann, fluchtend bezüglich der eingesetzten Antennenleiste 30 eine Ausnehmung 4 eingebracht, die mindestens so groß ist wie der Außenquerschnitt der Antennenleiste 30, so dass diese auch dann ungehindert eingesetzt werden kann, wenn sie sich im eingesetzten Zustand bis in den Bereich des oberen Endes der vertikalen Montageprofils 10 bzw. 10' erstreckt, um auch die obere Einbauposition des Einbauraums 6 auszunutzen. Auf diese Weise kann die Antennenleiste 30 über das vertikale Rahmenprofil 10 bzw. 10' hinausstehend eingesetzt und dann nach unten verschoben werden, um sie zu fixieren.

Wie die Fig. 2, 4, 5 und 8 weiter zeigen, geht der Anlageabschnitt 12 an seinem außenseitigen Rand in einen außenseitigen Seitenwandabschnitt 15 des Montageprofils 10 bzw. 10' über, der nach hinten gerichtet ist, und in dem eine weitere vertikale Lochreihe 15.1 mit Löchern für Montagezwecke angeordnet ist. Die Aufnahme 14 könnte auch auf ihrer Außenseite mit einer weiteren Wand parallel zur innenseitigen Begrenzungswand 13 versehen sein, die mit ihrem vorderen Rand höchstens bis in die frontseitige Montageebene vorsteht.

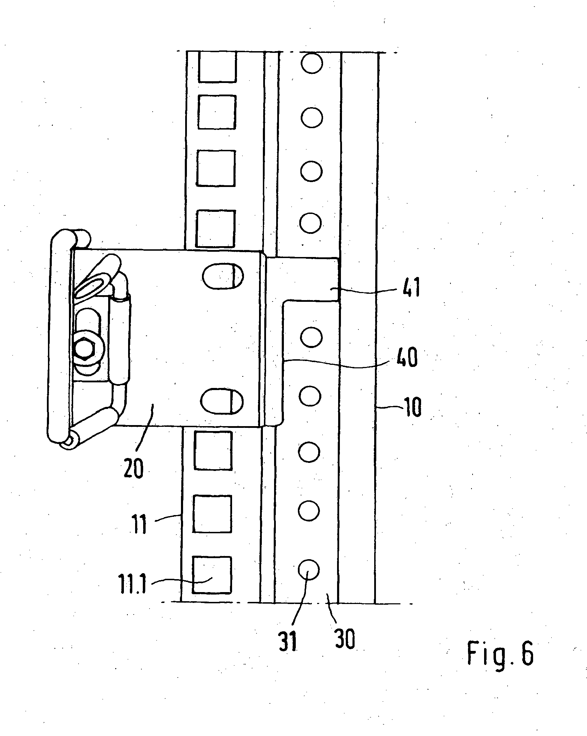

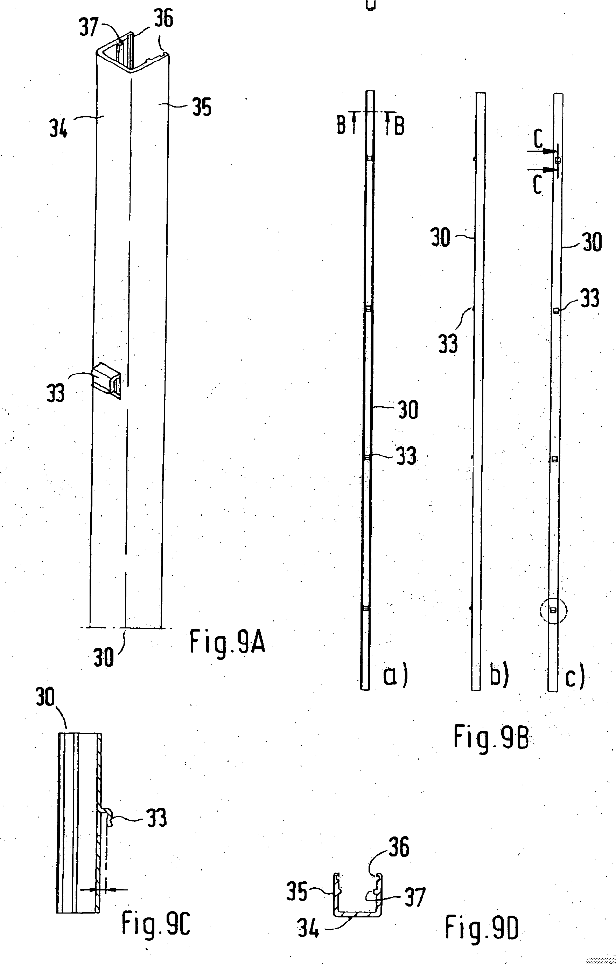

Wie Fig. 8 und weiterhin die Fig. 9A bis 9D zeigen, besitzt die Antennenleiste 30 ein Gehäuse mit U-förmigem, z. B. quadratischem oder rechtförmigem Querschnitt mit einem Basisschenkel 34 und zwei Seitenschenkeln 35. In die im eingebauten Zustand zur Frontseite des Schaltschranks bzw. Racks gerichtete vordere Seite ist ein Abdeckteil 32 eingesetzt, beispielsweise eingeschnappt oder eingerastet. Zum Halten des Abdeckteils 32 sind auf der Innenseite der Seitenschenkel 35 in der Nähe des freien Randes derselben längs verlaufende Haltenuten 36 ausgebildet, die die freien Ränder des vorzugsweise flachen Abdeckteils 32 vorderseitig und rückseitig überfassen. Das Abdeckteil 32 kann auch oder zusätzlich eingeklebt werden. Außerdem sind, gegenüber den Haltenuten 36 tiefer nach innen versetzt, auf der Innenseite der Seitenschenkel 35 sich gegenüberliegende Halterippen 37 eingebracht, so dass im Inneren des U-förmigen Gehäuses der Antennenleiste 30 weitere Elemente beispielsweise mittels Halteplättchen fixiert werden können, wie z. B. die genannten Antennenelemente und Zuführleitungen sowie auch später noch beschriebene Leuchtelemente 31 (vgl. Fig. 6). Das Abdeckteil 32 ist vorzugsweise lichtdurchlässig durchscheinend bzw. transparent ausgebildet, so dass Licht der Leuchtelemente 31 durchtritt, wobei die Leuchtelemente klar umgrenzt in ihrer Position individuell erkennbar sind, jedoch der Innenraum der Antennenleiste 30 vorzugsweise nicht einsehbar ist. Hierzu eignet sich entsprechend eingetrübtes Glas mit möglichst geringer Lichtschwachung und z. B. ohne selektive spektrale Filtereigenschaften.

Wie Fig. 6 zeigt, sind die Leuchtelemente 31 ebenfalls in einem gleichmäßigen Rasterabstand über die Länge der Antennenleiste 30 angeordnet, wobei z. B. drei Leuchtelemente 31 pro Höheneinheit HE eingesetzt sind. Zwei der Leuchtelemente 31 liegen dabei neben dem Montageabschnitt 21 bzw. Verbindungsabschnitt 42 des Halteelementes 40 frei, und befinden sich bei eingesetzter Einbaueinheit 20 z. B. im angesteuerten leuchtenden Zustand, während ein drittes Leuchtelement 31 pro Höheneinheit bei eingesetzter Einbaueinheit 20 von dem vorzugsweise lichtundurchlässigen Tragabschnitt 41 des Halteelementes 40 abgedeckt ist, das sich in vertikaler Richtung nur über ein Drittel einer Höheneinheit HE erstreckt. Auf diese Weise werden einem Betrachter die Einbaulagen auch visuell gut erkennbar angezeigt, wobei besetzte Einbaupositionen leicht wahrnehmbar sind. Die Leuchtelemente 31 können über (eine nicht gezeigte) Steuereinheit, wie sie beispielsweise in der eingangs genannten DE 10 2007 034 437 A1 angegeben ist, angesteuert werden, wobei verschiedene Ansteuerungsweisen in Frage kommen, z. B. in verschiedenen Farben unter Einsatz von verschiedenfarbig betreibbaren Leuchtdioden, oder in verschiedenen Blinkmodi bzw. im Dauerlichtbetrieb. Die Leuchtelemente 31 werden dabei in Abhängigkeit von den von den Transponderelementen 44 erhaltenen und über die Antennenelemente an die Steuereinheit weitergeleiteten Informationen angesteuert. Die Antennenelemente können im selben Rasterabstand und in enger Nähe zu den Leuchtelementen 31 angeordnet sein, so dass sich eine eindeutige Informationserfassung und Positionszuordnung erreichen lässt Weitere Signalisierungen können in Abhängigkeit von dem Betriebszustand der Einbaueinheiten, ihren in den Transponderelementen 44 z. B. werkseitig programmierten Eigenschaften und ihrer Einbaulage gesteuert werden, wobei die Steuereinheit auch mit einer übergeordneten Überwachungseinrichtung und Registrierungseinrichtungen zusammenarbeiten kann.

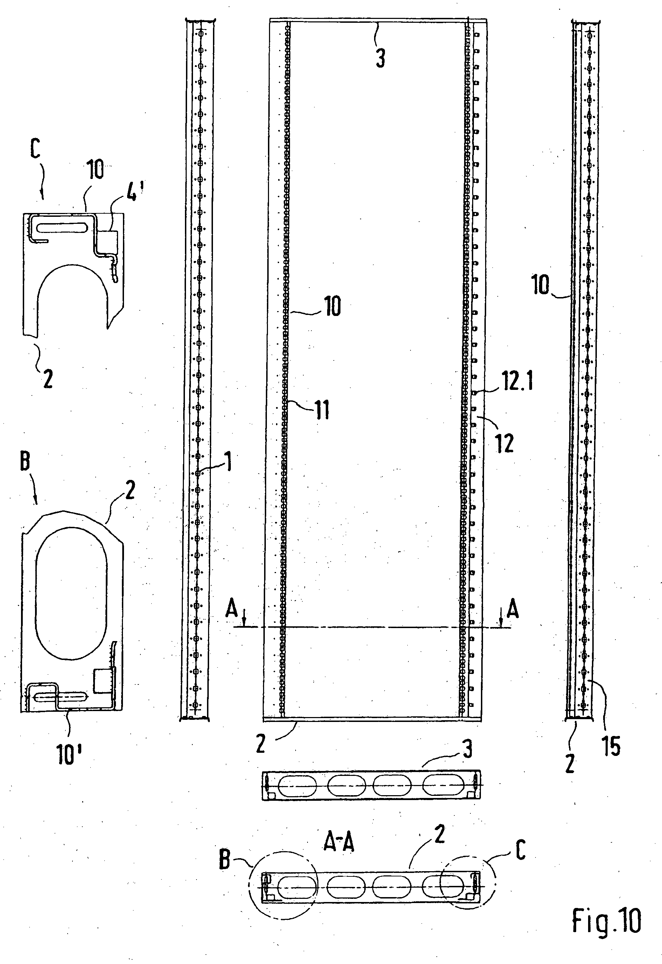

Wie Fig. 10 zeigt, kann auch in dem unteren Rahmenschenkel 2 eine Ausnehmung 4' zum Verschieben der Antennenleiste 30 nach unten eingebracht sein. Die beiden vertikalen Montageprofile 10, 10' können gleichen oder unterschiedlichen Aufbau aufweisen, wie die vergrößerten Ausschnitte B und C zeigen.

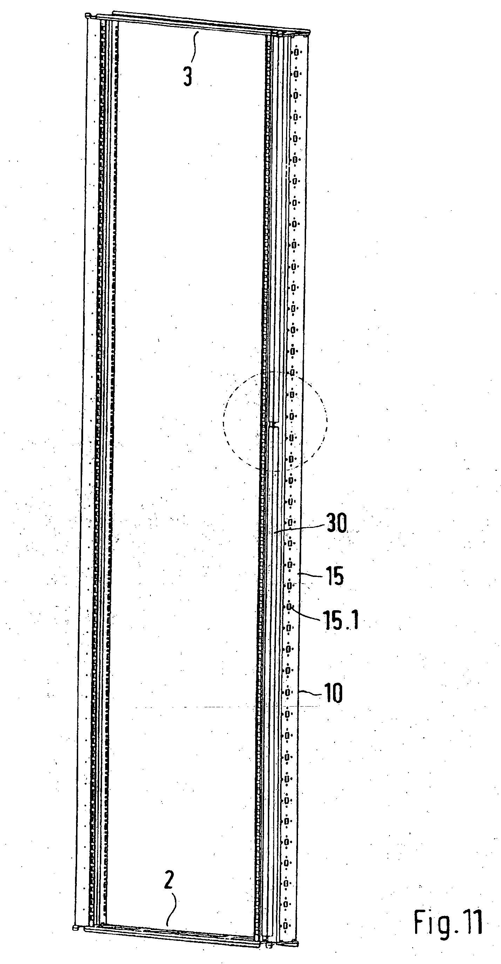

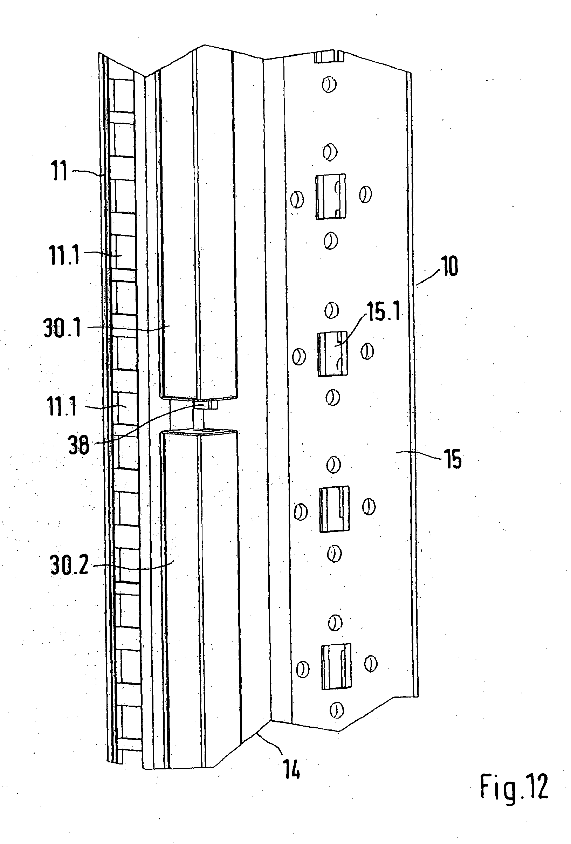

Wie die Fig. 11 und die vergrößerte Ausschnittdarstellung in Fig. 12 zeigen, kann die Antennenleiste 30 aus mehreren Leistenmodulen 30.1, 30.2 zusammengesetzt sein, die über eine Stecker-/Kupplungseinheit elektrisch leitend zusammengesteckt werden können, wobei sich auch eine mechanische Verbindung ergibt, die aber zusätzlich noch mittels Rastelementen oder anderen Steckelementen ergänzt sein kann. Die Leistenmodule 30.1, 30.2 erstrecken sich vorzugsweise über mehrere Höheneinheiten und besitzen eine Länge, die auf verschiedene gängige Schaltschrankhöhen abgestimmt ist, so dass das kleinste Modul in einen Schaltschrank niedrigster Höhe passt und eine Antennenleiste 30 für einen höheren Schaltschrank durch Zusammenstecken mehrerer Leistenmodule 30.1, 30.2 erhalten wird.

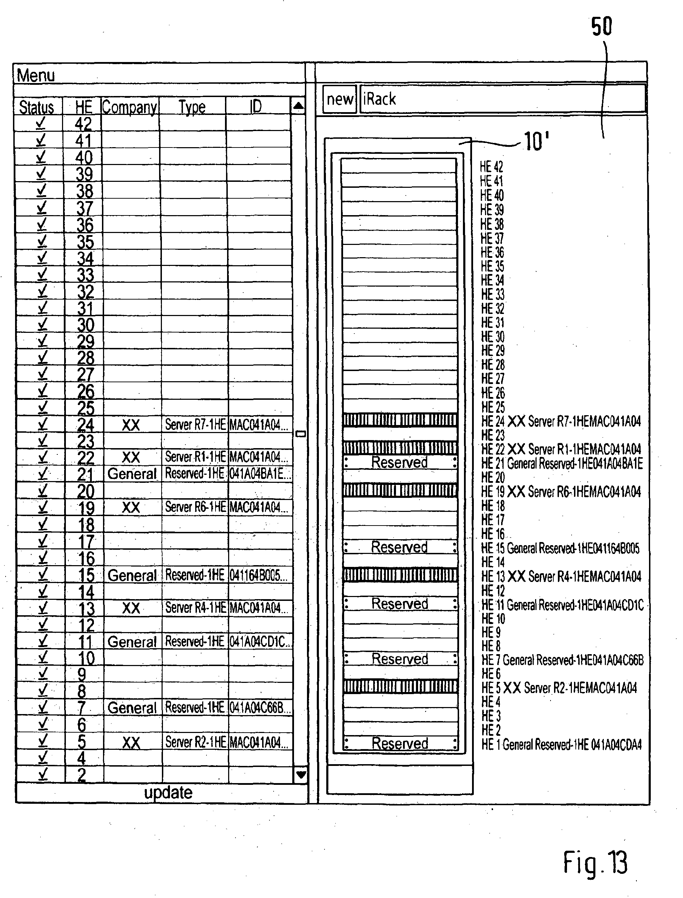

Fig. 13 zeigt ein Beispiel für eine Anzeige auf einem Sichtschirm einer entfernten Anzeigestation, wobei auf einer Bildschirmanzeige 50 die Montageebene eines Schaltschranks oder Racks mit seinen Höheneinheiten HE1 bis HE42 mit belegten Einbaupositionen dargestellt ist. Ferner sind neben der Einbauebene Zusatzinformationen zu den einzelnen Einbaueinheiten, beispielsweise Servereinheiten, eingeblendet, die den aktuellen Status und Eigenschaften der Einbaueinheiten 20 wiedergeben. Derartige Informationen können auf den Transponderelementen 44, insbesondere RFID-Tags, zum Teil gespeichert, zum anderen Teil erzeugt werden und über die Antennenelemente und die Steuereinheit weitergeleitet werden. Auch können die auf den RFID-Tags enthaltenen und an die Steuereinheit, Registriereinrichtung bzw. überge-ordnete Überwachungseinrichtung weitergeleiteten Informationen mit dort gespeicherten weiteren Informationen zu den Einbaueinheiten 20, wie z. B. technischen Daten, ergänzt werden.

## Patentansprüche

1. Schaltschrank oder Rack mit einer Montageeinrichtung, die einen Einbauraum (6) für anwenderseitige Einbaueinheiten (20) frontseitig seitlich begrenzende vertikale Montageprofile (10, 10') mit frontseitigen flachen Befestigungsabschnitten (11), die in einer gemeinsamen Montageebene liegen, zum Anbringen von seitlich abstehenden Montageabschnitten (21) der Einbaueinheiten (20) aufweist, und mit Komponenten einer Erfassungseinrichtung zum Feststellen, ob an einer Einbaupositiön des Einbauraums (6) eine Einbaueinheit (20) vorhanden ist oder nicht, wobei die Komponenten der Erfassungseinrichtung eine an einem Möntageprofil (20) angebrachte vertikal verlaufende Antennenleiste (30) mit darin angeordneten Antennenelementen und an den Einbaueinheiten (20) angeordneten Transponderelementen aufweisen, wobei das Montageprofil (10) eine an den Querschnitt der Antennenleiste (30) zumindest teilweise angepasste, nach vorne zur Frontseite offene, seitlich außerhalb des benachbarten Befestigungsabschnittes (11) angeordnete Aufnahme (14) mit einem gegenüber der frontseitigen Ebene des Befestigungsabschnitts (11) zumindest um die Querschnittstiefe der Antennenleiste (30) zurückversetzten Ablageabschnitt (12) und mit einer die Aufnahme (14) auf deren dem Einbauraum (6) zugekehrter Seite begrenzenden innenseitigen Begrenzungswand (13) aufweist, die sich zur Außenseite an den Befestigungsabschnitt (11) anschließt, so dass sich an den Befestigungsabschnitt (11) zur Außenseite eine innenseitige Begrenzungswand der Aufnahme (14) für die Antennenleiste (30) anschließt, wobei die innenseitige Begrenzungswand an ihrem von der Frontseite abliegenden rückseitigen Ende rechtwinklig in den nach außen zeigenden Anlageabschnitt (12) übergeht, der parallel zu der Montageebene (5) ausgerichtet ist, wobei eine Rückseite der Antennenleiste (30) beim Einsetzen an den Anlageabschnitt (12) in Anlage gebracht ist, wobei die Vorderseite des Anlageabschnitts in einem solchen Abstand von der frontseitigen Montageebene zurückversetzt ist, dass die Vorderseite der Antennenleiste (30) nicht über die Frontebene der Befestigungsabschnitte (11) übersteht, und wobei die Antennenleiste (30) mit ihrer Frontseite in der Montageebene liegt oder gegenüber dieser um höchstens 10 mm zurückversetzt ist, wobei das jeweilige Transponderelement vor der Frontseite der Antennenleiste (30) angeordnet und auf einem die Antennenleiste (30) überlappenden Tragabschnitt eines Halteelementes (40) befestigt ist.

2. Schaltschrank oder Rack nach Anspruch 1,
**dadurch gekennzeichnet,**
**dass** der Anlageabschnitt (12) und die innenseitige Begrenzungswand (13) im Querschnitt der Aufnahme (14) rechtwinklig zueinander angeordnet sind, wobei der Anlageabschnitt (12) parallel zur Montageebene (5) ausgerichtet ist.

3. Schaltschrank oder Rack nach Anspruch 1 oder 2,
**dadurch gekennzeichnet,**
**dass** die Begrenzungswand (13) rechtwinklig in den Befestigungsabschnitt (11) übergeht.

4. Schältschrank oder Rack nach einem der vorhergehenden Ansprüche,
**dadurch gekennzeichnet,**
**dass** der Anlageabschnitt (12) über einen Zwischenabschnitt oder unmittelbar schräg oder rechtwinklig in einen von der Frontseite weg nach hinten gerichteten Seitenwandabschnitt (15) übergeht oder rechtwinklig in eine nach vorn zur Frontseite hin gerichteten und höchstens bis in diese vorstehende außenseitige Begrenzungswand der Aufnahme (14) übergeht.

5. Schaltschrank oder Rack nach Anspruch 4,
**dadurch gekennzeichnet,**
**dass** die außenseitige Begrenzungswand über einen Zwischenabschnitt oder unmittelbar in den rechtwinklig oder schräg zur vorderen Schaltschrank- oder Rackebene gerichteten Seitenwandabschnitt (15) übergeht.

6. Schaltschrank oder Rack nach einem der vorhergehenden Ansprüche,
**dadurch gekennzeichnet, dass**
die Befestigungsabschnitte (11) zum Anschlagen der Montageabschnitte ausgebildet sind und vertikale Lochreihen (11.1) mit einem oder mehreren in einem regelmäßigen Rasterabstand angeordneten Befestigungslöchern (11.2) aufweisen.

7. Schaltschrank oder Rack nach Anspruch 6,
**dadurch gekennzeichnet,**
**dass** das Halteelement (40) mit einem Verbindungsabschnitt (42) an dem benachbarten Montageabschnitt (21) der zugeordneten Einbaueinheit (20) angebracht ist.

8. Schaltschrank oder Rack nach einem der vorhergehenden Ansprüche,
**dadurch gekennzeichnet,**
**dass** in dem Anlageabschnitt (12) eine Haltelochreihe (12.1) mit in regelmäßigem Rasterabstand angeordneten Haltelöchern (12.2) angeordnet ist.

9. Schaltschrank oder Rack nach Anspruch 8,
**dadurch gekennzeichnet,**
**dass** die Haltelöcher (122) quadratisch oder rechteckförmig mit in Längsrichtung des Montageprofils (10) verlaufenden Längsseiten ausgebildet sind und dass die Antennenleiste (30) auf ihrer dem Anlageabschnitt (12) zugekehrten Rückseite mit Haltehaken (33) versehen ist, die auf den Abstand der Haltelöcher (12.2) oder ein Vielfaches davon abgestimmt sind und vertikale Hakenabschnitte aufweisen, die eine geringere Länge besitzen als die lichte Öffnungsweite der Haltelöcher (12.2) in vertikaler Richtung und die soweit von der rückseitigen Außenfläche der Antennenleiste (30) beabstandet sind, dass sie einen die Haltelöcher (122) umgebenden Wandbereich des Anlageabschnitts (12) mit einer Klemmkraft hintergreifen.

10. Schaltschrank oder Rack nach einem der vorhergehenden Ansprüche,
**dadurch gekennzeichnet,**
**dass** die Antennenleiste (30) quadratischen oder rechteckförmigen Querschnitt besitzt und bezüglich der eingebauten Lage auf ihrer Frontseite mit einem daran fest oder abnehmbar fixierten Abdeckteil (32) versehen ist.

11. Schaltschrank oder Rack nach Anspruch 10,
**dadurch gekennzeichnet,**
**dass** das Abdeckteil (32) zumindest abschnittsweise transparent ausgebildet ist und dass auf der oder im inneren der Antennenleiste (30) Leuchtelemente (31) angeordnet sind, die in Längsrichtung der Antennenleiste (30) in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch das transparente Abdeckteil (32) positionsgenau sichtbar sind.

12. Schaltschrank oder Rack nach einem der vorhergehenden Ansprüche,
**dadurch gekennzeichnet,**
**dass** im Inneren der Antennenleiste (30) im Raster einer Höheneinheit HE oder einem ganzzahligen Vielfachen oder gleichmäßigen Teilabstand davon in Längsrichtung der Antennenleiste (30) voneinander beabstandete Antennenelemente angeordnet sind.

13. Schaltschrank oder Rack nach einem der Ansprüche 7 bis 12,
**dadurch gekennzeichnet,**
**dass** in den Montageabschnitten (21) der Einbaueinheiten (20) auf den Abstand von Befestigungslöchern (11.2) oder ein ganzzahliges Vielfaches davon abgestimmte Montagelöcher (21.1) angeordnet sind und
**dass** in Befestigungsabschnitten (42) der Halteelemente (40) auf die Montagelöcher (21.1) abgestimmte Öffnungen (43) angeordnet sind, wobei der Abstand von der Mitte der Befestigungslöcher (11.2) bis zum außenseitigen Rand der Antennenleiste (30) so groß ist wie die Ausdehnung der Halteelemente (40) von der Mitte der Öffnungen (43) zum äußeren Rand des Trageabschnitts (41).

14. Schaltschrank oder Rack nach einem der vorhergehenden Ansprüche,
**dadurch gekennzeichnet,**
**dass** die vertikalen Montageprofile (10, 10') sich zwischen einem oberen und unteren horizontalen Montageschenkel oder Rahmenschenkel (2, 3) des Schaltschranks oder Racks erstrecken und
**dass** in Verlängerung der Antennenleiste (30) in ihrer Einbaulage in dem oberen und/oder unteren horizontalen Montageschenkel oder Rahmenschenkel (2, 3) eine Ausnehmung (4, 4') eingebracht ist, die größer ist als der Querschnitt der Antennenleiste.

15. Schaltschrank oder Rack nach einem der vorhergehenden Ansprüche,
**dadurch gekennzeichnet,**
**dass** Transponderelemente (44) als RFID-Tags ausgebildet sind.

## Claims

1. A switch cabinet or rack with an installation device, comprising an installation space (6) for vertical installation sections (10, 10') on the front that laterally limit user mounting units (20), with flat attachment sections (11) on the front that are on a common installation plane, for the attachment of laterally protruding installation segments (21) of the mounting units (20), and with components of a detection device to determine whether a mounting unit (20) exists on a mounting position of the installation space (6), wherein the components of the detection device comprise an antenna strip (30) with antenna elements arranged therein and transponder elements arranged extending vertically on the installation section (20), wherein the mounting section (10) comprises a retainer (14) at least partially adapted to the cross-section of the antenna strip (30), open to the front, and arranged laterally outside of the adjacent attachment section (11), with an abutting section (12) that is recessed relative to the front plane of the mounting section (11) by at least the depth of the cross-section of the antenna strip (30), and with a limiting boundary wall (13) facing the retainer (14) on its side facing the installation space (6), and which adjoins the outer side of the attachment section (11) so that an inner boundary wall of the retainer (14) adjoins on the attachment section (11) to the outside for the antenna strip (30), wherein the inner boundary wall on its rear end at a distance from the front side transitions at a right angle into the abutting section (12) facing outward, which is oriented parallel to the mounting plane (5), wherein one rear side of the antenna strip (30) during insertion abuts on the abutting section (12), wherein the front side of the abutting section is recessed from the mounting plane at a distance such that the front side of the antenna strip (30) does not project beyond the front plane of the attachment sections (11), and wherein the antenna strip (30) lies in the mounting plane with its front end or is recessed relative to same by a maximum of 10 mm, wherein the respective transponder element is arranged ahead of the front side of the antenna strip (30) and is attached to a support section of a retaining element (40) overlapping the antenna strip (30).

2. The switch cabinet or rack according to claim 1, **characterized in that** the abutting section (12) and the inner boundary wall (13) in the cross-section of the retainer (14) are configured reciprocally at right angles to one another, wherein the abutting section (12) is aligned parallel to the mounting plane (5).

3. The switch cabinet or rack according to claim 1 or 2, **characterized in that** the boundary wall (13) transitions into the attachment section (11) at a right angle.

4. The switch cabinet or rack according to any of the preceding claims, **characterized in that** the abutting section (12) transitions by means of an intermediate section directly sloping or at a right angle into a sidewall section (15) facing away from the front side towards the back or transitions at a right angle into an outer boundary wall of the retainer (14) facing to the front side and projects at most up to said boundary wall.

5. The switch cabinet or rack according to claim 4, **characterized in that** the outer boundary wall transitions by means of an intermediate section at a right angle or sloping into the sidewall section (15) facing the front plane of the switch cabinet or rack.

6. The switch cabinet or rack according to any of the preceding claims, **characterized in that** the attachment sections (11) are developed for attachment of the assembly sections and comprise vertical rows of holes (11.1) with one or multiple mounting holes (11.2) that are arranged at regular grid spacing.

7. The switch cabinet or rack according to claim 6, **characterized in that** the retaining element (40) is attached with a connection element (42) onto the adjacent installation segment (21) of the assigned mounting unit (20).

8. The switch cabinet or rack according to any of the preceding claims, **characterized in that** a retaining hole row (12.1) with retaining holes (12.2) at regular grid spacing is arranged in the abutting section (12).

9. The switch cabinet or rack according to claim 8, **characterized in that** the retaining holes (122) *[sic]* are developed with quadratic or rectangular sidewalls extending in the longitudinal direction of the assembly section (10) and that the antenna strip (30) is provided with retaining hooks (33) on its rear side facing the abutting section (12) that are matched to the spacing of the retaining holes (12.2) or a multiple thereof and have vertical hook sections, which have a smaller length than the clear opening width of the retaining holes (12.2) in the vertical direction and are spaced apart from the rear outer surface of the antenna strip (30) at a distance such that they engage behind the wall area of the abutting section (12) surrounding the retaining holes (122).

10. The switch cabinet or rack according to any of the preceding claims, **characterized in that** the antenna strip (30) has a quadratic or rectangular cross-section and with respect to the installed position is provided on its front side with a cover (32) that is firmly or removably attached to it.

11. The switch cabinet or rack according to claim 10, **characterized in that** the cover (32) is developed transparent at least in sections and that light elements (31) are arranged on or inside of the antenna strip (30) in the longitudinal direction of the antenna strip (30) at regular grid spacing in the grid of a height unit HU in integer multiples or at uniform spacing therefrom, and can be separately controlled and the exact position of which in the lit state are visible through the transparent cover (32).

12. The switch cabinet or rack according to any of the preceding claims, **characterized in that** in the interior of the antenna strip (30), antenna elements are arranged at a distance from one another in the longitudinal direction of the antenna strip (30) in the grid of a height unit HU or in an integer multiples or at uniform spacing therefrom.

13. The switch cabinet or rack according to any of the claims 7 to 12, **characterized in that** mounting holes (21.1) are arranged in the installation segments (21) of the mounting units (20) spaced matched to the spacing of the mounting holes (11.2) or an integer multiple thereof and that openings (43) are arranged in the mounting sections (42) of the retaining elements (40) that are matched to the mounting holes (21.2), wherein the distance from the center of the mounting holes (11.2) to the outer edge of the antenna strip (30) is as large as the extension of the retaining elements (40) from the center of the openings (43) to the outer edge of the support section (41).

14. The switch cabinet or rack according to any of the preceding claims, **characterized in that** the vertical installation sections (10, 10') extend between an upper and a lower horizontal assembly leg or frame piece (2, 3) of the switch cabinet or rack, and that in extending the antenna strip (30) in its installation position a recess (4, 4') that is larger than the cross-section of the antenna strip is introduced in the upper and/or lower horizontal assembly leg or frame piece (2, 3).

15. The switch cabinet or rack according to any of the preceding claims, **characterized in that** the transponder elements (44) are developed as RFID tags.

## Revendications

1. Armoire de commande ou rack avec un dispositif de montage, qui comprend un espace de montage (6) pour des profilés de montage (10, 10') verticaux délimitant latéralement, côté frontal, des unités de montage côté utilisateur (20), avec des portions de fixation plates (11) côté frontal, qui se trouvent dans un plan de montage commun, pour le montage de portions de montage (21), écartes latéralement, des unités de montage (20), et avec des composants d'un dispositif de détection permettant de déterminer si, à une position de montage de l'espace de montage (6), une unité de montage (20) est présente ou non, les composants du dispositif de détection comprenant une baguette d'antenne (30) s'étendant verticalement, montée sur un profilé de montage (20), avec des éléments d'antenne disposés à l'intérieur, et des éléments de transpondeur disposés sur les unités de montage (20), le profilé de montage (10) comprenant un logement (14) au moins partiellement adapté à la section transversale de la baguette d'antenne (30), ouverte vers l'avant du côté frontal, disposé latéralement à l'extérieur de la portion de fixation (11) adjacente, avec une portion d'appui (12) décalée par rapport au plan côté frontal de la portion de fixation (11), d'au moins la profondeur de section transversale de la baguette d'antenne (30) et avec une paroi de limitation (13) interne délimitant le logement (14) sur son côté orienté vers l'espace de montage (6), qui se raccorde, à l'extérieur, à la portion de fixation (11), de façon à ce que, à la portion de fixation (11) vers l'extérieur, se raccorde une paroi de limitation interne du logement (14) pour la baguette d'antenne (30), la paroi de limitation interne passant, au niveau de son extrémité arrière opposée au côté frontal, qui est orientée parallèlement au plan de montage (5), un côté arrière de la baguette d'antenne (30) étant mise en appui, lors de l'insertion, contre la portion d'appui (12), le côté avant de la portion d'appui étant décalé à une distance du plan de montage côté frontal de façon à ce que le côté avant de la baguette d'antenne (30) ne dépasse du plan frontale des portions de fixation (11) et la baguette d'antenne (30) se trouvant, avec son côté frontal, dans le plan de montage ou étant décalée de celui-ci de 10 mm maximum, l'élément de transpondeur correspondant étant disposé devant le côté frontal de la baguette d'antenne (30) et étant fixé sur une portion de support d'un élément de maintien (40) superposé à la baguette d'antenne (30).

2. Armoire de commande ou rack selon la revendication 1, caractérisé(e) en ce que la portion d'appui (12) et la paroi de limitation interne (13) sont disposés à angle droit l'une par rapport à l'autre dans la section transversale du logement (14), la portion d'appui (12) étant orientée parallèlement au plan de montage (5).

3. Armoire de commande ou rack selon la revendication 1 ou 2, caractérisé(e) en ce que la paroi de limitation (13) passe perpendiculairement dans la portion de fixation (11).

4. Armoire de commande ou rack selon l'une des revendications précédentes, caractérisé(e) en ce que la portion d'appui (12) passe, par l'intermédiaire d'une portion intermédiaire ou directement oblique ou perpendiculaire, vers une portion de paroi latérale (15) orientée vers l'arrière loin du côté frontal ou perpendiculairement vers une paroi de limitation externe du logement (14), orientée vers l'avant vers le côté frontal et au maximum jusque dans cette paroi de limitation en saillie.

5. Armoire de commande ou rack selon la revendication 4, caractérisé(e) en ce que la paroi de limitation externe passe, par l'intermédiaire d'une portion intermédiaire ou directement, vers la portion de paroi latérale (15) orientée de manière parallèle ou oblique par rapport au plan avant de l'armoire de commande ou du rack.

6. Armoire de commande ou rack selon l'une des revendications précédentes, caractérisé(e) en ce que les portions de fixations (11) sont conçues pour la butée des portions de montage et comprennent des séries de trous verticaux (11.1), avec des trous de fixation (11.2) disposés à une distance ou à plusieurs distances régulières.

7. Armoire de commande ou rack selon la revendication 6, caractérisé(e) en ce que l'élément de maintien (40) est monté, avec une portion de liaison (42), sur la portion de montage (21) adjacente à l'unité de montage (20) correspondant.

8. Armoire de commande ou rack selon l'une des revendications précédentes, caractérisé(e) en ce que, dans la portion d'appui (12), se trouve une série de trous de maintien (12.1) avec des trous de maintien (12.2) disposés à des intervalles réguliers.

9. Armoire de commande ou rack selon la revendication 8, caractérisé(e) en ce que les trous de maintien (122) sont de forme carrée ou rectangulaire avec des côtés longitudinaux s'étendant dans la direction longitudinale du profilé de montage (10) et en ce que la baguette d'antenne (30) est munie, sur son côté arrière orienté vers la portion d'appui (12), de crochets de maintien (33) disposés aux mêmes intervalles que les trous de maintien (12.2) ou à un multiple de ceux-ci et qui comprennent des portions de crochets verticales qui présentent une longueur inférieure à la largeur d'ouverture maximale des trous de maintien (12.2) dans la direction verticale et qui sont éloignés de la surface extérieure arrière de la baguette d'antenne (30) de façon à ce que qu'ils s'emboîtent par l'arrière dans une zone de la paroi de la portion d'appui (12) entourant les trous de maintien (122) avec une force de serrage.

10. Armoire de commande ou rack selon l'une des revendications précédentes, caractérisé(e) en ce que la baguette d'antenne (30) présente une section transversale carrée ou rectangulaire et est munie, par rapport à la position montée sur son côté frontal, d'une partie de recouvrement (32) fixée de manière définitive ou amovible.

11. Armoire de commande ou rack selon la revendication 10, caractérisé(e) en ce que la partie de recouvrement (32) est conçue de manière au moins partiellement transparente et en ce que, sur la baguette d'antenne (30) ou à l'intérieur de celle-ci se trouvent des éléments d'éclairage (31) disposés dans la direction longitudinale de la baguette d'antenne (30) à des intervalles réguliers dans la trame d'une unité de hauteur HE ou à un multiple entier ou une distance partielle régulière de celle-ci, qui sont contrôlables séparément et visibles, avec précision de position, à travers la partie de recouvrement transparente (32) dans l'état lumineux.

12. Armoire de commande ou rack selon l'une des revendications précédentes, caractérisé(e) en ce que, à l'intérieur de la baguette d'antenne (30), se trouvent des éléments d'antennes écartés entre eux dans la trame d'une unité de hauteur HE ou à un multiple entier ou une distance partielle régulière entre eux.

13. Armoire de commande ou rack selon l'une des revendications 7 à 12, caractérisé(e) en ce que, dans les portions de montage (21) des unités de montage (20), se trouvent des trous de montage (21.1) adaptés à la distance des trous de fixation (11,.2) ou à un multiple entier de celle-ci et en ce que, dans les portions de fixation (42) des éléments de maintien (40), se trouvent des ouvertures (43) adaptées au trous de montage (21.1), la distance entre le centre des trous de fixation (11.2) et le bord extérieur de la baguette d'antenne (30) étant telle égale à l'extension des éléments de maintien (40) du centre des ouvertures (43) au bord extérieur de la portion de support (41).

14. Armoire de commande ou rack selon l'une des revendications précédentes, caractérisé(e) en ce que les profilés de montage verticaux (10, 10') s'étendent entre un montant de montage horizontal supérieur et un montant de montage horizontal inférieur ou un montant de cadre (2, 3) de l'armoire de commande ou du rack et en ce que, dans le prolongement de la baguette d'antenne (30), dans sa position de montage dans le montant de montage horizontal supérieur et/ou le montant de montage horizontal inférieur ou le montant de cadre (2, 3), se trouve un évidement (4, 4') dont la taille est supérieure à celle de la section transversale de la baguette d'antenne.

15. Armoire de commande ou rack selon l'une des revendications précédentes, caractérisé(e) en ce que les éléments de transpondeurs (44) sont conçus comme des balises RFID.
